Europäisches Patentamt

European Patent Office

Office européen des brevets

(19)

(11) Veröffentlichungsnummer: **0 222 086**
**B1**

(12) ## EUROPÄISCHE PATENTSCHRIFT

(45) Veröffentlichungstag der Patentschrift:
26.09.90

(51) Int. Cl.⁵: **H01P 1/17,** H01P 1/185

(21) Anmeldenummer: **86111865.1**

(22) Anmeldetag: **16.10.82**

(60) Veröffentlichungsnummer der früheren Anmeldung
nach Art. 76 EPÜ: **0105963**

(54) **Polarisationswandler.**

(43) Veröffentlichungstag der Anmeldung:
**20.05.87 Patentblatt 87/21**

(73) Patentinhaber: **ANT Nachrichtentechnik GmbH,
Gerberstrasse 33, D-7150 Backnang(DE)**

(45) Bekanntmachung des Hinweises auf die Patenterteilung:
**26.09.90 Patentblatt 90/39**

(72) Erfinder: **Mörz, Günter, Dr.-Ing., Moserstrasse 19,
D-7140 Ludwigsburg(DE)**

(84) Benannte Vertragsstaaten:
**BE CH DE FR GB IT LI NL SE**

(56) Entgegenhaltungen:
**US-A- 2 425 345
US-A- 2 458 579
US-A- 3 403 356
US-A- 3 845 485**

**L. THOUREL: "Dispositifs à ferrites pour
micro-ondes", 1969, MASSON et Cie, Paris, FR**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die vorliegende Erfindung betrifft einen Polarisationswandler für Mikrowellen, bestehend aus einem Wellenleiter mit darin längs seiner Achse angeordneten Mitteln, die ein Bezugssystem bilden aus senkrecht aufeinanderstehenden Längsschnittebenen, in denen die orthogonalen Komponenten einer in den Wellenleiter eingespeisten Welle unterschiedlich große Phasendrehungen erfahren, wobei das Bezugssystem um die Längsachse des Wellenleiters drehbar ist.

Ein derartiger Polarisationswandler ist aus der amerikanischen Patentschrift 2 607 849 bekannt. Dabei ist in einem Rundhohlleiter in Wellenausbreitungsrichtung eine dielektrische Platte angeordnet. Diese Platte stellt das oben erwähnte orthogonale Bezugssystem dar. Denn eine parallel zu der dielektrischen Platte verlaufende Wellenkomponente erfährt eine von der Länge der Platte abhängige Phasenverschiebung, wohingegen die dazu senkrecht orientierte Wellenkomponente nahezu unverzögert den Hohlleiter durchläuft.

Gemäß der US-PS 2 607 849 ist die dielektrische Platte um die Hohlleiterachse drehbar gelagert, wodurch das Bezugssystem unter jeden beliebigen Winkel zu der Polarisationsebene der eingespeisten Welle ausgerichtet werden kann. Von der Lage des Bezugssystems relativ zu der Polarisationsebene der eingespeisten Welle hängen die Beträge der auf das Bezugssystem ausgerichteten orthogonalen Wellenkomponenten ab, so daß durch Verdrehen der dielektrischen Platte z.B. die Elliptizität einer Welle beeinflußt oder deren Polarisationsrichtung geändert werden kann. Schließlich findet ein solcher Polarisationswandler Anwendung als variabler Phasenschieber, sofern der Polarisationswandler 180°-Phasendrehung zwischen den orthogonalen Ebenen des Bezugssystems aufweist und zwischen 90°-Polarisationswandlern angeordnet ist.

Der der US-PS 2 607 849 zugrunde liegende Polarisationswandler hat zwar den Vorteil, daß sein Bezugssystem in jede beliebige Winkellage gebracht und somit einer Welle uneingeschränkt jede gewünschte Phasendrehung verliehen werden kann. Da hier aber die Ausrichtung des Bezugssystems auf rein mechanischem Wege mittels der axial drehbar gelagerten dielektrischen Platte erfolgt, sind der Winkelgeschwindigkeit des Bezugssystems sehr enge Grenzen gesetzt.

Der Erfindung liegt daher die Aufgabe zugrunde, einen Polarisationswandler der eingangs genannten Art zu schaffen, dessen Bezugssystem so realisiert ist, daß es sehr schnell in jede beliebige Winkellage gegenüber der Polarisationsebene der eingespeisten Welle eingestellt, bzw. daß es einer bis zu sehr hohen Winkelgeschwindigkeiten reichenden, kontinuierlichen Rotation ausgesetzt werden kann.

Diese Aufgabe wird durch die Merkmale des Anspruchs 1 gelöst.

Zweckmäßige Ausführungen und vorteilhafte Verwendungsmöglichkeiten der Erfindung gehen aus den Unteransprüchen hervor.

Erst der erfindungsgemäße Polarisationswandler ermöglicht es, auf sehr einfache Weise z.B. einen endlos drehenden Phasenschieber oder einen Phasen- bzw. Frequenzmodulator zu realisieren, der sehr verlustarm (< 1dB Dämpfung) arbeitet. Außerdem vermeidet ein solch elektrisch gesteuerter Polarisationswandler die üblicherweise bei einer Anordnung mit mechanisch beweglichen Teilen entstehenden Störeinflüsse auf die durchlaufende Welle.

Anhand von in der Zeichnung dargestellten Ausführungsbeispielen wird nun die Erfindung näher erläutert.

Es zeigen

Fig. 1 die Vorderansicht und
Fig. 2 die perspektivische Darstellung eines Polarisationswandlers mit in einem koaxialen Hohlleiter radial angeordneten Dioden und
Fig. 3 einen mit dem Polarisationswandler realisierten Phasenschieber.

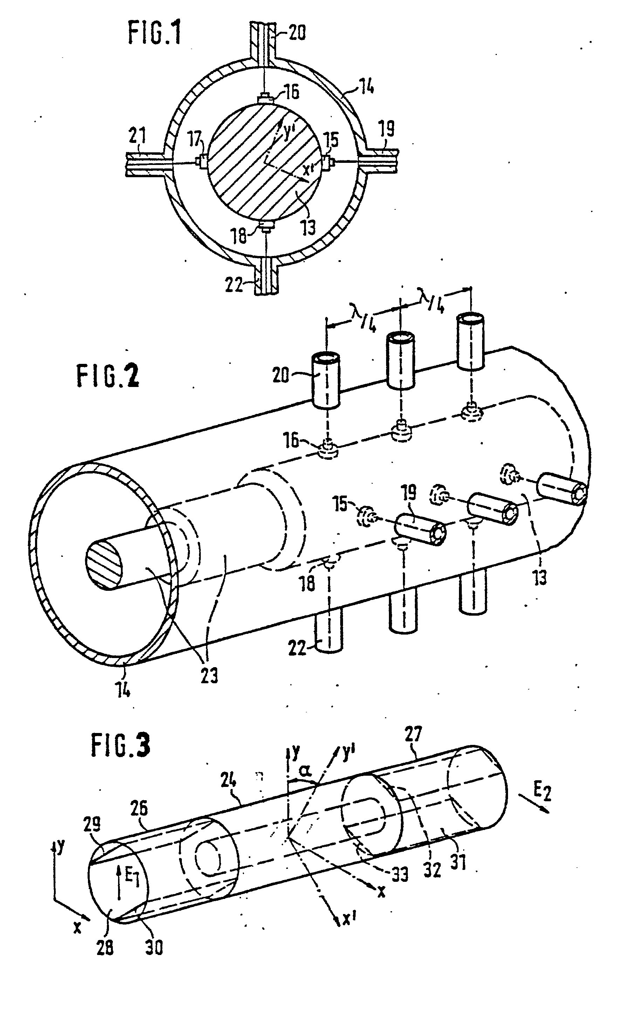

Ein Ausführungsbeispiel eines Polarisationswandlers mit einem elektrisch steuerbaren Bezugssystem x', y' zeigen die Figuren 1 (Vorderansicht) und 2 (perspektivische Seitenansicht). Dieser Polarisationswandler besteht aus einem Koaxial-Hohlleiter, zwischen dessen Innenleiter 13 und Außenleiter 14 mehrere Dioden 15, 16, 17, 18 - vorzugsweise Kapazitätsdioden - angeordnet sind. Die Dioden sind mit dem Innenleiter 13 kontaktiert und erhalten über durch den Außenleiter 14 hindurchgeführte koaxiale Zuführungsleitungen 19, 20, 21, 22 ihre Vorspannungen. Die Anordnung von vier Dioden am Umfang ist nur ein Beispiel. Eine größere Zahl vereinfacht die kontinuierliche Drehung des Bezugssystems durch die Ansteuerung. Es müssen aber mindestens drei Dioden am Umfang verteilt angeordnet sein, sonst läßt sich kein drehendes Bezugssystem realisieren.

Das oben angesprochene Bezugssystem x', y' wird durch die kapazitiven Impedanzen der Dioden gebildet. Durch entsprechende Wahl der um den Innenleiter verteilten Diodenimpedanzen läßt sich auch hier dem Bezugssystem jede beliebige radiale Lage verleihen. Über die Vorspannungen, von denen die Diodenimpedanzen abhängen, kann das Bezugssystem sowohl in diskrete Winkellagen gebracht als auch einer kontinuierlichen Rotation mit wählbarer Winkelgeschwindigkeit ausgesetzt werden. Wie in der Fig. 2 angedeutet, sind längs der Hohlleiterachse im Abstand von jeweils λ/4 mehrere Querschnittsebenen vorgesehen, in denen mindestens drei transversal ausgerichtete Dioden angeordnet sind. Die Anzahl der mit Dioden bestückten Querschnittsebenen hängt davon ab, welche Phasenverschiebung zwischen den sich in den orthogonalen Längschnittebenen des Bezugssystems ausbreitenden Wellenkomponenten erreicht werden soll, ob z.B. ein 90°- oder ein 180°-Polarisationswandler realisiert werden soll.

Um Reflexionen an der Trennstelle, zwischen dem Koaxial-Hohlleiter und einem sich daran evtl. anschließenden anderen Hohlleiterbauelement zu vermindern, ist der Innenleiter 13 am Ende mit Abstufungen 23 versehen (vgl. Fig. 2).

Im folgenden soll nun der Einsatz eines Polarisationswandlers als Phasenschieber nach dem aus der US-PS 2 607 849 bereits bekannten Prinzip erörtert werden.

Bei dem in Fig. 3 dargestellten Phasenschieber ist ein 180°-Polarisationswandler 24 der oben beschriebenen Art eingesetzt. Vor und hinter diesem variablen 180°-Polarisationswandler ist jeweils ein 90°-Polarisationswandler 26 bzw.27 angeordnet. Beide 90°-Polarisationswandler 26 und 27 brauchen nur ein starres Bezugssystem aufzuweisen. Ein derartiger Polarisationswandler mit festem Bezugssystem kann z.B. dadurch realisiert werden, daß in den Hohlleiter eine sich in Wellenausbreitungsrichtung erstreckende dielektrische Platte eingesetzt wird (vgl. US-PS 2 607 849), oder daß, wie Fig. 3 zeigt, der Hohlleiter 26 bzw. 27 mit einem Dielektrikum 28 bzw. 31 ausgefüllt wird, das mit zwei einander gegenüberliegenden, parallel zur Hohlleiterachse verlaufenden Abflachungen 29 und 30 bzw. 32 und 33 versehen ist.

Der in Fig. 3 schematisch dargestellte Phasenschieber funktioniert folgendermaßen: Eine linear polarisierte Welle $E_1$ tritt in den ersten 90°-Polarisationswandler 26 ein. Aufgrund des Dielektrikums 28 mit gegenüber der Polarisationsebene der Welle $E_1$ um 45° geneigten Abflachungen 29 und 30 wird die Welle in eine zirkular polarisierte umgewandelt. Diese zirkular polarisierte Welle durchläuft dann den 180°-Polarisationswandler 24, im dem das Bezugssystem x', y' um einen Winkel $\alpha$ gegenüber der Polarisationsebene der eingespeisten Welle $E_1$ gedreht ist. Das in der Fig. 3 eingezeichnete Koordinatensystem x, y bezieht sich auf die Welle $E_1$ am Eingang des Phasenschiebers, wobei die y-Achse parallel und die x-Achse senkrecht zu der Polarisationsebene der Welle $E_1$ orientiert ist. Die am Ausgang des 180°-Polarisationswandlers erscheinende gegensinnig zirkular polarisierte Welle wird dann durch den sich anschließenden 90°-Polarisationswandler 27 in eine linear polarisierte Welle $E_2$ rückgewandelt. Die aus dem Phasenschieber austretende Welle $E_2$ hat wegen der Verdrehung des Bezugssystems des 180°-Polarisationswandlers um den Winkel $\alpha$ gegenüber der eintretenden Welle $E_1$ eine Phasenverschiebung von 2 $\alpha$ erfahren. Besonders vorteilhaft ist die Tatsache, daß sich hiermit ein endlos drehender Phasenschieber aufbauen läßt.

Da der erfindungsgemäße, elektrisch steuerbare Polarisationswandler sehr schnelle und sehr große Phasenänderungen ermöglicht, läßt sich mit seinem Einsatz der soeben beschriebene Phasenschieber in vorteilhafter Weise als Phasenmodulator verwenden; so z.B. als digitaler Phasenmodulator, bei dem eine Umtastung zwischen mehreren diskreten Phasenzuständen in Abhängigkeit entsprechend zugeordneter Bitworte erfolgt.

Da man das Bezugssystem x', y' des erfindungsgemäßen Polarisationswandlers mit einer wählbaren Winkelgeschwindigkeit

$$\frac{d\alpha}{dt}$$

rotieren lassen kann, eröffnet sich die Möglichkeit, den in den Fig. 1, 2 dargestellten Phasenschieber als Frequenzwandler auszunutzen. Die Kreisfrequenz der austretenden Welle $E_2$ ändert sich gegenüber der Kreisfrequenz der eintretenden Welle $E_1$ um den Wert

$$2 \cdot \frac{d\alpha}{dt} ,$$

wobei es von der Drehrichtung des Bezugssystems abhängt, ob die Kreisfrequenz um diesen Wert erhöht oder vermindert wird.

**Patentansprüche**

1. Polarisationswandler für Mikrowellen, bestehend aus einem Wellenleiter mit darin längs seiner Achse angeordneten Mitteln, die ein Bezugssystem bilden aus senkrecht aufeinanderstehenden Längsschnittebenen, in denen die orthogonalen Komponenten einer in den Wellenleiter eingespeisten Welle unterschiedlich große Phasendrehungen erfahren, wobei das Bezugssystem um die Längsachse des Wellenleiters drehbar ist, dadurch gekennzeichnet, daß in einem Koaxial-Wellenleiter in mindestens zwei Querschnittsebenen im Abstand von etwa λ/4 über den Umfang des Innenleiters (13) verteilt, mindestens drei Dioden (15, 16, 17, 18) angeordnet sind und daß den radial zwischen dem Innen- (13) und dem Außenleiter (14) angeordneten Dioden von außen Vorspannungen zugeführt sind, über die die Lage des von den Diodenimpedanzen abhängigen Bezugssystems (x', y') einstellbar ist.

2. Polarisationswandler nach Anspruch 1, dadurch gekennzeichnet, daß dieser so dimensioniert ist, daß die parallel zu den orthogonalen Achsen des Bezugssystems orientierten Komponenten einer den Polarisationswandler durchlaufenden Welle eine gegenseitige Phasenverschiebung von 180° erfahren.

3. Polarisationswandler nach Anspruch 2, dadurch gekennzeichnet, daß ein Phasenschieber realisiert ist, wobei vor dem 180°-Polarisationswandler (24) ein 90°-Polarisationswandler (26) angeordnet ist, der eine linear polarisierte Welle ($E_1$) in eine zirkular polarisierte Welle umwandelt und wobei hinter dem 180°-Polarisationswandler (24) ebenfalls ein 90°-Polarisationswandler (27) angeordnet ist, der die zirkular polarisierte Welle nach einer durch den 180°-Polarisationswandler bewirkten Drehrichtungsumkehr wieder in eine linear polarisierte Welle ($E_2$) umwandelt.

4. Polarisationswandler nach einem der vorhergehenden Ansprüche, gekennzeichnet durch die Verwendung als Phasenmodulator.

5. Polarisationswandler nach Anspruch 4, gekennzeichnet durch die Verwendung als digitaler Phasenmodulator, wobei den einzelnen Phasenzuständen diskrete Winkellagen des Bezugssystems zugeordnet sind.

6. Polarisationswandler nach einem der vorhergehenden Ansprüche, gekennzeichnet durch die Verwendung als Frequenzwandler, wobei das Bezugssystem mit einer die Frequenzänderungen bestimmenden Winkelgeschwindigkeit

$$\frac{d\ \alpha(t)}{dt}$$

rotiert.

## Claims

1. Polarisation transformer for microwaves and consisting of a wave guide with means which are arranged therein along its axis and form a reference system of mutually perpendicular longitudinal sectional planes, in which the orthogonal components of a wave fed into the wave guide experience differently large phase rotations, wherein the reference system is rotatable about the longitudinal axis of the wave guide, characterised thereby, that at least three diodes (15, 16, 17, 18) are arranged distributed over the circumference of the inner conductor (13) in at least two cross-sectional planes at a spacing of about $\lambda/4$ in a co-axial wave guide and that bias voltages, by way of which the position of the reference system (x', y') dependent on the diode impedances is adjustable, are fed from outside to the diodes arranged radially between the inner conductor (13) and the outer conductor (14).

2. Polarisation transformer according to claim 1, characterised thereby, that this is so dimensioned that the components, which are oriented parallelly to the orthogonal axes of the reference system, of a wave travelling through the polarisation transformer experience a mutual phase displacement of 180°.

3. Polarisation transformer according to claim 2, characterised thereby, that a phase shifter is realised, wherein a 90° polarisation transformer (26), which transforms a linearly polarised wave ($E_1$) into a circularly polarised wave, is arranged in front of the 180° polarisation transformer (24) and a 90° polarisation transformer (27), which transforms the circularly polarised wave back again into a linearly polarised wave ($E_2$) after a reversal of direction of rotation effected by the 180° polarisation transformer, is likewise arranged behind the 180° polarisation transformer (24).

4. Polarisation transformer according to one of the preceding claims, characterised by the use as phase modulator.

5. Polarisation transformer according to claim 4, characterised by the use as digital phase modulator, wherein discrete angular positions of the reference system are associated with the individual phase states.

6. Polarisation transformer according to one of the preceding claims, characterised by the use as frequency transformer, wherein the reference system rotates at an angular speed

$$\frac{d\ \alpha(t)}{dt}$$

determining the frequency changes.

## Revendications

1. Transducteur de polarisation pour micro-ondes, constitué d'un guide d'ondes avec, disposés à l'intérieur et le long de son axe, des moyens qui forment un système de référence constitué de plans de coupe longitudinaux disposés perpendiculairement l'un à l'autre, et dans lesquels les composantes orthogonales d'une onde amenée dans le guide d'ondes subissent des rotations de phase de différentes valeurs, étant précisé que le système de référence peut tourner autour de l'axe longitudinal du guide d'ondes, caractérisé par le fait que dans un guide d'ondes coaxial, sont disposées, réparties dans au moins deux plans de coupe, à la distance d'environ $\lambda/4$ le long de la périphérie du guide intérieur (13), au moins trois diodes (15, 16, 17, 18) et par le fait qu'aux diodes, disposées radialement entre le conducteur intérieur (13) et le conducteur extérieur (14), sont amenées, de l'extérieur, des tensions de polarisation au moyen desquelles on peut modifier la position du système de référence (x', y') qui dépend des impédances des diodes.

2. Transducteur de polarisation selon la revendication 1, caractérisé par le fait qu'il est dimensionné de façon que les composantes, orientées parallèlement aux axes orthogonaux du système de référence, d'une onde traversant le transducteur de polarisation subissent un déphasage mutuel de 180°.

3. Transducteur de polarisation selon la revendication 2, caractérisé par le fait que c'est un déphaseur qui est réalisé, étant donné qu'en avant du transducteur de polarisation à 180° (24) est disposé un transducteur de polarisation à 90° (26) qui convertit une onde ($E_1$) polarisée linéairement en une onde polarisée circulairement et étant donné que derrière le transducteur de polarisation à 180° (24) est également disposé un transducteur de polarisation à 90° (27) qui convertit à nouveau l'onde polarisée circulairement, après le changement de sens de rotation opéré par le transducteur de polarisation à 180°, en une onde ($E_2$) polarisée linéairement.

4. Transducteur de polarisation selon l'une des revendications précédentes, caractérisé par le fait qu'on l'emploie comme modulateur de phase.

5. Transducteur de polarisation selon la revendication 4, caractérisé par le fait qu'on l'emploie comme modulateur de phase numérique, les différents états de phase correspondant à des positions angulaires discrètes du système de référence.

6. Transducteur de polarisation selon l'une des revendications précédentes, caractérisé par le fait qu'on l'emploie comme transformateur de fréquence, le système de référence tournant à une vitesse de rotation

$$\frac{d\ \alpha(t)}{dt}$$

qui détermine les modifications de fréquence.

FIG.1

FIG.2

FIG.3